# EUROPEAN PATENT SPECIFICATION

(11) **EP 4 752 566 B1**
(45) Date of publication and mention of the grant of the patent: **18.11.2026**
(21) Application number: 24216692.4
(22) Date of filing: 29.11.2024
(51) Int. Cl.: G01R 15/18

(54) **CURRENT TRANSDUCER**
STROMWANDLER
TRANSDUCTEUR DE COURANT

(43) Date of publication of application: 03.06.2026
(73) Proprietor: LEM International SA, 1217 Meyrin (CH)
(72) Inventor: TROMBERT, Stéphan, 74320 LESCHAUX (FR)
(74) Representative: reuteler & cie SA

(56) References cited:
- CN-A- 109 581 041
- US-A1- 2009 243 590
- US-A1- 20240 385 227

## Description

The present invention relates to a current transducer for measuring an alternating current in a conductor, in particular, to a current transducer based on a Rogowski coil.

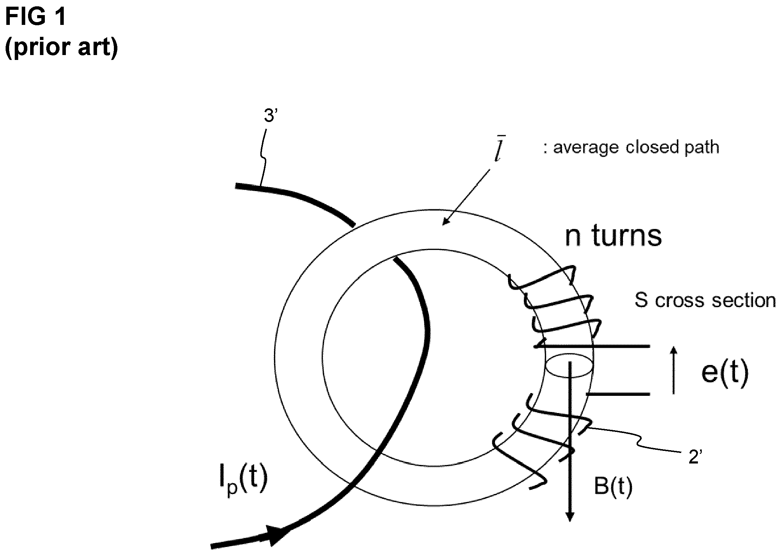

Current transducers for measuring an alternating current in a conductor based on magnetic induction are known in the prior art (see figures 1-3). This type of current transducers 1' comprises an inductor 2' for providing an induction voltage induced by a time-varying magnetic field created by the alternating current in the conductor 3', and a processing unit 10' configured to convert the induction voltage into an output signal representing the alternating current by integrating the induction voltage over time and calibrating the gain of the coil. For the example a Rogowski coil, the induction voltage e(t) in the inductor 2' is given by $\left|e\left(t\right)\right| = \frac{{μ}_{0} nS}{\overline{l}} \frac{{dI}_{p} \left(t\right)}{dt} = M \frac{{dI}_{p} \left(t\right)}{dt} ,$
S is the cross-section of the Rogowski coil, i.e., the area of one of the small loops,
*n* is the number of turns,
*I* is the average closed path of the Rogowski coil around the primary conductor 3',
µ₀ vacuum magnetic permeability,
*I*ₚ is the primary current in the primary conductor 3',
M is the resulting proportionality constant.

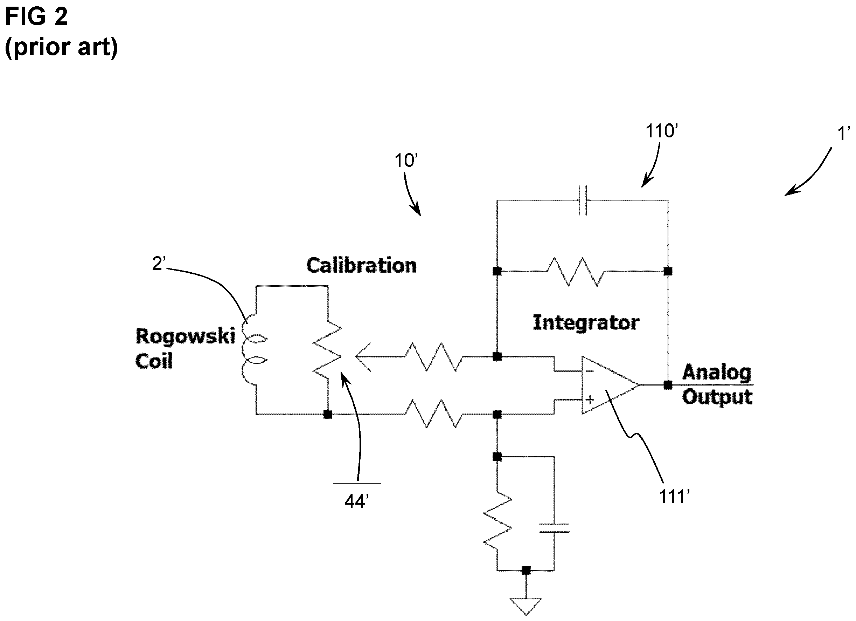

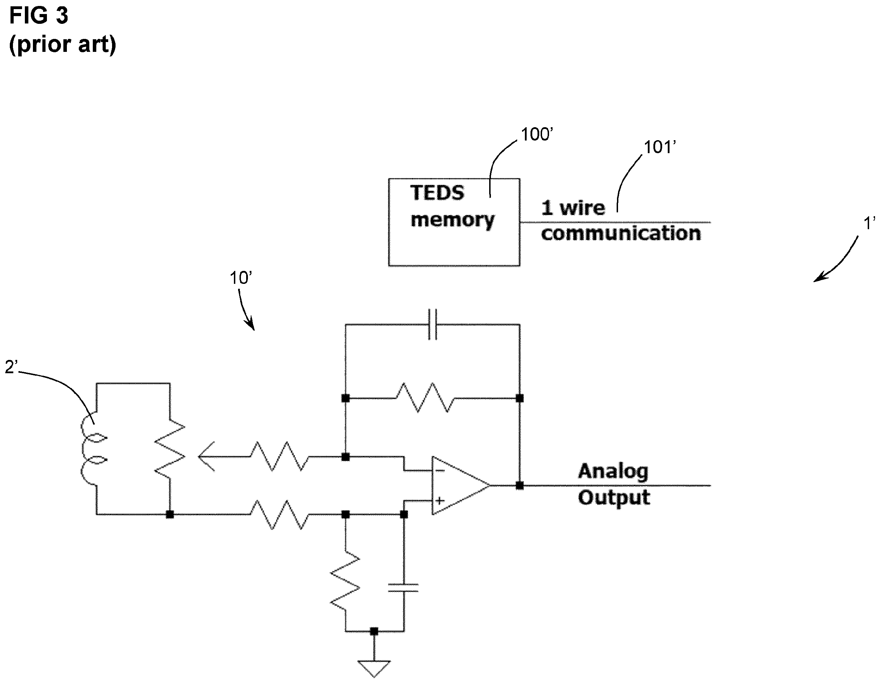

Typically, these current transducers are based on a fully analog solution if an analog output signal is desired. In these devices, the processing unit 10' comprises an analog integrator 110' comprising an operational amplifier 111' and passive components as shown in figures 2 and 3.

Despite the apparent simplicity, this approach requires high-quality components that are expensive. Also, in most cases, a gain calibration of the coil needs to be performed manually by adjusting a potentiometer 44'.

The trend of the market goes to higher accuracies on extended temperatures ranges. The drawback of full analog solutions is that passive components are sensitive to temperature variations, meaning that, most of the time, an added temperature compensation is needed.

Another problem of a pure analog integrator lies in the fact that it will integrate the slightest parasitic offset (e.g. due to the operation amplifier), with the effect that the output will always be unstable and will drift sooner or later to saturate at the upper or lower level. Consequently, it is essential to limit this drift, using a static gain or an active compensation stage. A drawback of offset rejection circuits is that they generate several degrees of phase error which poses a major problem for the measurement of power. In this type of application, it is therefore necessary to add a phase-shift compensation stage, which generally consists of a low-pass filter. Unfortunately, the correction will not be constant, but will depend on the frequency, meaning it will be necessary to optimize the design to minimize the phase difference at the fundamental frequency, typically 16 2/3, 50, 60 or 400 Hz.

TEDS (Transducer Electronic DataSheet, IEEE 1457.4) is being used more and more: The key parameters of the transducers are stored in a memory and customers read this memory to adjust their frontends and measurements (see figure 3).

Relevant prior art is disclosed in CN 109 581 041 A.

In view of the foregoing, it is an object of the invention to provide a current transducer for measuring an alternating current that is accurate and economical to produce.

It is advantageous to provide a current transducer that is accurate in a large measurement range of current amplitudes.

It is advantageous to provide a current transducer that is accurate in a large temperature range.

It is advantageous to provide a current transducer that can be easily and quickly calibrated. It is advantageous to provide a current transducer that has a small phase error.

It is advantageous to provide a current transducer that provides TEDS data.

Objects of the invention have been achieved by providing a system according to claim 1.

Dependent claims set out various advantageous features of embodiments of the invention.

Disclosed herein is a current transducer for measuring an alternating current in a conductor, the current transducer comprising an inductor having a first connection point at a first electric potential corresponding to a first measurement voltage *V*a with respect to ground and a second connection point at a second electric potential corresponding to a second measurement voltage Vb with respect to ground, and a processing unit connected to the first and second connection points configured to convert an induction voltage induced in the inductor by said alternating current into an output signal of the current transducer representing a measurement of the alternating current.

The processing unit comprises a first analog-to-digital converter connected to the first connection point, a second analog-to-digital converter connected to the second connection point, and a linearity compensation network.

The linearity compensation network comprises:
a voltage divider connected between the first and second connection points and having a mid-point at a mid-point electric potential between the first electric potential and the second electric potential,
a subtractor connected to an output of the first analog-to-digital converter and an output of the second analog-to-digital converter, and
a mid-point voltage adjustment unit connected to an output of the subtractor or outputs of the first and second analog-to-digital converters, configured to adjust the mid-point electric potential based on the output of the subtractor or the outputs of the first and second analog-to-digital converters to maintain absolute values of the first and second measurement voltages *Va,* Vb greater than an error threshold *Th* for an alternating current with a peak amplitude smaller than a small amplitude current threshold *Th*₁.

In an advantageous embodiment, the the mid-point voltage adjustment unit is configured to adjust the mid-point electric potential based on the output of the subtractor or the outputs of the first and second analog-to-digital converters to maintain absolute values of the first and second measurement voltages *Va,* Vb greater than an error threshold *Th* for a voltage between the first and second connection points smaller than twice a small amplitude voltage threshold *Th*₂, wherein an alternating current with a peak amplitude equals to the small amplitude current threshold *Th*₁ induces a peak induction voltage that creates a voltage between the first and second connection points of twice the small amplitude voltage threshold *Th*₂.

In an advantageous embodiment, the mid-point voltage adjustment unit is configured to detect that the absolute values of the measurement voltages *Va,* Vb at inputs of the first and second analog-to-digital converters with respect to ground are both greater than the small amplitude voltage threshold *Th*₂ and thereupon set the mid-point electric potential to ground.

In an advantageous embodiment, the mid-point voltage adjustment unit is configured to detect that the absolute value of at least one of the measurement voltages *Va,* Vb at the inputs the first and second analog-to-digital converters with respect to ground is below the small amplitude voltage threshold *Th*₂ and thereupon set the mid-point electric potential to an adjustment voltage ΔV above ground or below ground.

In an advantageous embodiment, the adjustment voltage ΔV is selected in the range between 0.25 and 0.75 of the small amplitude voltage threshold *Th*₂, for example, the adjustment voltage ΔV is approximately half the small amplitude voltage threshold *Th*₂.

In an advantageous embodiment, the mid-point voltage adjustment unit comprises a decimation filter connected to the output of the subtractor configured to adjust the mid-point electric potential (φmid) based on an output of the decimation filter to maintain absolute values of measurement voltages *Va,* Vb at the inputs of the first and second analog-to-digital converters with respect to ground greater than the error threshold *Th* for the alternating current with the peak amplitude smaller than the small amplitude threshold *Th*₁.

In an advantageous embodiment, the mid-point voltage adjustment unit further comprises an absolute value unit and a comparator.

The absolute value unit may be configured to provide the absolute value of the output of the decimation filter, and the mid-point voltage adjustment unit may be configured to detect by the comparator the absolute value of the output of the decimation filter being less than a predefined comparator voltage Vcomp and thereupon set the mid-point electric potential (φmid) to the adjustment voltage ΔV above ground or below ground. The mid-point voltage adjustment unit may be configured to detect by the comparator the absolute value of the output of the decimation filter being greater than the predefined comparator voltage Vcomp and thereupon set the mid-point electric potential to ground.

In an advantageous embodiment, the inductor is a Rogowski coil.

In an advantageous embodiment, at least portions of the linearity compensation network and the first and second analog-to-digital converters are implemented in a field-programmable gate array (FPGA).

In an advantageous embodiment, the first and second analog-to-digital converters are sigma-delta modulators.

In an advantageous embodiment, the processing unit further comprises an output signal processing circuit for producing the output signal of the current transducer representing the alternating current, wherein the output signal processing circuit is connected to the output of the subtractor and comprises a digital low pass filter for integrating an output signal of the subtractor.

In an advantageous embodiment, the digital low pass filter has a transfer function of the form *Y* = *αZ + (1-α)Y⁻¹,* where the coefficient *α* is preferably an inverse of a power of 2.

In an advantageous embodiment, the output signal processing circuit further comprises a gain calibration unit for calibrating a gain of the inductor and/or compensating a gain of the digital low pass filter.

In an advantageous embodiment, the gain calibration unit comprises a multiplier and a third sigma-delta modulator with a constant input corresponding to the gain of the inductor and/or the gain of the digital low pass filter, wherein an output of the third sigma-delta modulator is connected to an input of the multiplier, wherein another input of the multiplier is connected to the output of the subtractor and an output of the multiplier is connected to an input of the digital low pass filter.

In an advantageous embodiment, the output signal processing circuit further comprises a fourth sigma-delta modulator connected to an output of the digital low pass filter.

In an advantageous embodiment, the output signal processing circuit further comprises an analog low pass filter connected to an output of the fourth sigma-delta modulator.

Further advantageous features of the invention will be apparent from the following detailed description of embodiments of the invention and the accompanying illustrations.

### Brief description of the figures

Figure 1 is a schematic view of a Rogowski coil;
Figure 2 is a schematic view of a current transducer comprising a Rogowski coil and an analog integrator;
Figure 3 is a schematic view of a current transducer comprising a Rogowski coil, an analog integrator and a TEDS memory;
Figure 4 is a schematic view of a sigma-delta modulator implemented with a field-programmable gate array and passive components according to an embodiment of the invention (top panel) and a typical output signal of the sigma-delta modulator (bottom panel);
Figure 5 is a schematic view of the relationship between the analog input and the sigma-delta equivalent output signal of the sigma-delta modulator of figure 4, showing a linear relationship at large signals (left panel) and a non-reliable zone near zero (right panel);
Figure 6 is a schematic view of a current transducer according to an embodiment of the invention;

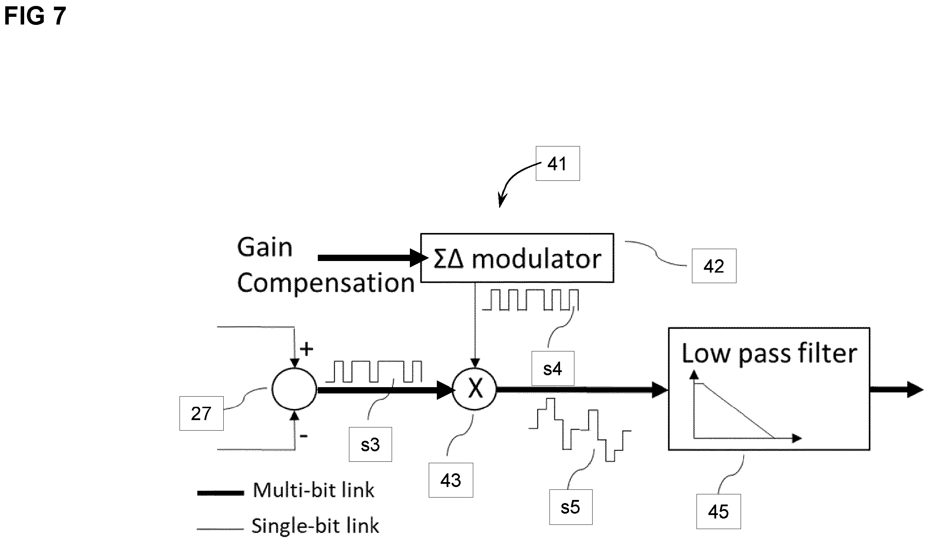

Figure 7 is a schematic view of an output signal processing circuit of a current transducer according to an embodiment of the invention;
Figure 8 is log-log plot of the filter gain versus frequency of the low pass filter of figure 7;
Figure 9 is a schematic view of a portion of an output signal processing circuit of a current transducer according to an embodiment of the invention for generating an analog output signal.

Referring to the figures, a current transducer 1 according to embodiments of the invention comprises an inductor 2 for providing an induction voltage e(t) induced by a time-varying magnetic field created by an alternating primary current *I*ₚ in a primary conductor 3.

The inductor 2 has a first connection point 4a at a first electric potential φa and a second connection point 4b at a second electric potential φb for measuring the induction voltage e(t). Typically, the inductor 2 has a non-zero resistance during use of the current transducer at the operating temperature, e.g., at room temperature. The circuit for measuring the induction voltage e(t) may further comprise one or more series resistors 22a, 22b between the first connection point 4a and the inductor 2 and/or between the second connection point 4b and the inductor 2.

The current transducer 1 further comprises a processing unit 10 connected to the first and second connection points 4a, 4b configured to convert the induction voltage e(t) into an output signal of the current transducer representing a measurement of the alternating current. In preferred embodiments, the inductor 2 is a Rogowski coil. In a variant, the inductor 2 is a pick-up coil.

The processing unit 10 of the current transducer 1 of the present invention is at least partially implemented using digital electronics replacing analog electronics of the pure analog solutions of the prior art. In preferred embodiments, the processing unit 10 is at least partially implemented using a field-programmable gate array (FPGA) 11.

The use of digital electronics enables a high accuracy stability over a wide temperature range, because the digital signal processing accuracy only depends on its clock frequency, which remains stable (with a frequency variation of a few parts per million per degree Celsius (ppm/°C)).

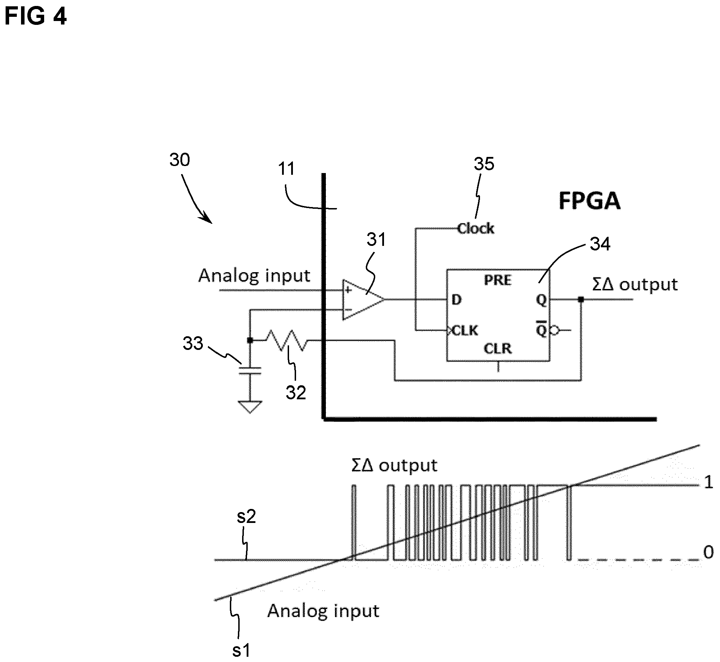

The processing unit 10 comprises analog-to-digital converters, which are preferably sigma-delta modulators. The top panel of figure 4 shows an exemplary implementation of a sigma-delta modulator 30 using an FPGA 11 and passive components. The sigma-delta modulator 30 comprises an analog comparator 31 and a d-type flip-flop 34 implemented in the FPGA 11 and a passive integration network comprising a resistor 32 and a capacitor 33. The comparator 31 may be part of the FPGA 11 or external to the FPGA depending on the needs. The comparator 31 may be implemented by an operational amplifier. The plus-input of the comparator 31 is used as the analog signal input of the sigma-delta modulator 30. The output of the comparator 31 is connected to the data input D of the d-type flip-flop 34. The digital signal output of the sigma-delta modulator 30 is connected to the data output Q of the d-type flip-flop 34. The data output Q of the d-type flip-flop 34 is also connected to the minus-input of the comparator 31 via the resistor 32. The minus-input of the comparator 31 is connected to ground via the capacitor 33. The d-type flip-flop 34 is connected to the clock 35 of the FPGA 11. The bottom panel of figure 4 shows a typical output signal s2 of the sigma-delta modulator in comparison with a linear analog input signal s1.

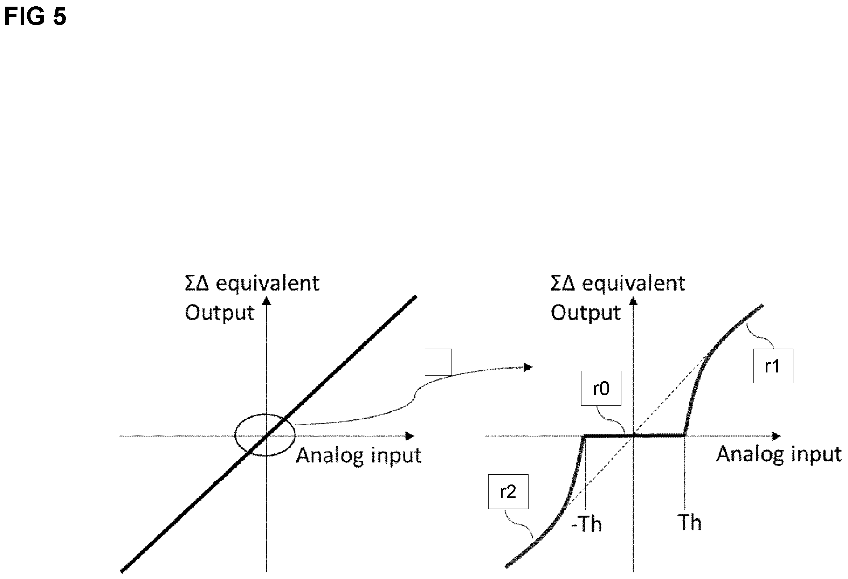

The equivalent output of sigma-delta modulator is essentially linear with respect to the analog input (see left panel of figure 5). However, the linearity of analogue-to-digital converters and in particular the linearity of sigma-delta modulators is affected by comparator errors (such as hysteresis or propagation times) at low input values. The right panel of figure 5 is zoomed in near zero compared to the left panel of figure 5. The equivalent output signal of the sigma-delta modulator is zero for analog input magnitudes below an error threshold *(Th).* Therefore, the measurement is not reliable in the zone *r*₀ near zero, approximately between *-Th* and + *Th.* The measurement is reliable for analog input magnitudes greater than *Th* in the zones *r*₁ and *r*₂, in which the equivalent output signal is linear with respect to the analog input.

In practice, alternating currents to be measured have mostly periodic waveforms, in particular, sinusoidal waveforms. If the peak amplitude of the alternating current is large compared to the error threshold *Th,* the relative error during the zero crossing is insignificant compared to the peak amplitude and the measurement is reliable. If the peak amplitude of the alternating current is not much larger than the error threshold *Th,* the relative error during the zero crossing is significant compared to the peak amplitude and the measurement is unreliable.

The processing unit 10 comprises a first analog-to-digital converter 30a connected to the first connection point 4a, a second analog-to-digital converter 30b connected to the second connection point 4b, and a linearity compensation network 20.

An input of the first analog-to-digital converter 30a is connected to the first measurement electric potential φa and an input of the second analog-to-digital converter 30b is connected to the second measurement electric potential φb.

In preferred embodiments, the first and second analog-to-digital converters 30a, 30b are sigma-delta modulators. The output of a sigma-delta modulator is a bitstream. Single-bit links are indicated in the figures as thin lines.

The linearity compensation network 20 is at least configured to correct the aforementioned error for an alternating current with a periodic waveform having a peak amplitude which is not much larger than the error threshold *Th,* for example, the peak amplitude is smaller than 10 times the error threshold *Th* or the peak amplitude is smaller than 100 times the error threshold *Th* or the peak amplitude is smaller than 1000 times the error threshold *Th* depending on the requirements on the relative error of the measurement with respect to the peak amplitude. The linearity compensation network 20 at least maintains the aforementioned relative error during the zero crossing insignificantly small for an alternating current with a periodic waveform having a peak amplitude which is much larger than the error threshold *Th,* for example, the peak amplitude is larger than 10 times the error threshold *Th* or the peak amplitude is larger than 100 times the error threshold *Th* or the peak amplitude is larger than 1000 times the error threshold *Th* fulfilling desired requirements on the relative error with respect to the peak amplitude.

The linearity compensation network 20 comprises a voltage divider 21 connected between the first and second connection points 4a, 4b and having a mid-point 4c at a mid-point electric potential φmid between the first electric potential φa and the second electric potential φb.

The voltage divider 21 comprises a first measurement resistor 21a between the first connection point 4a and the mid-point 4c, and a second measurement resistor 21b between the mid-point 4c and the second connection point 4b. The voltage divider 21 may comprise additional series resistors 21a, 21b between the first and second connection points 4a, 4b and connection ends of the inductor 2.

The linearity compensation network 20 further comprising a subtractor 27 and a mid-point voltage adjustment unit 23. An output of the first analog-to-digital converter 30a and an output of the second analog-to-digital converter 30b are connected to inputs of the subtractor 27.

The subtraction of the bitstreams s2 of the two sigma-delta modulators 30a, 30b with the two-level digital output voltages of {-V0, +V0} or {0, +V0} by the subtractor 4 creates a three-level digital output signal s3, which is represented by a multi-bit vector stream. Multi-bit links are indicated in the figures as thick arrows.

Direct arithmetic operations on sigma-delta bitstreams in FPGAs are possible and have the following advantages:
- Relatively cheap FPGAs can be used for these arithmetic operations. The development of an alternative solution, such as DSP slices or multipliers in silicon is more expensive.
- The operations are performed without interrupting the flow of data, improving the real time characteristics of the application.
- FPGAs' internal resources are saved, and the speed is increased because these calculations only involve bits or very small vectors of bits.

The mid-point voltage adjustment unit 23 is configured to adjust the mid-point electric potential φmid based on outputs of the first and second analog-to-digital converters 30a, 30b to maintain absolute values of measurement voltages *Va,* Vb at the inputs of the first and second analog-to-digital converters with respect to ground greater than the error threshold *Th* for an alternating current with a peak amplitude smaller than a small amplitude current threshold *Th*₁. A corresponding small amplitude voltage threshold *Th*₂ for the measurement voltages *Va,* Vb is defined as follows. An alternating current with a peak amplitude equals to the small amplitude current threshold *Th*₁ induces a peak induction voltage that creates a voltage between the first and second connection points 4a, 4b of twice the small amplitude voltage threshold *Th*₂.

For example, the small amplitude voltage threshold *Th*₂ may be defined as 10 times the error threshold *Th* or 100 times the error threshold *Th* or 1000 times the error threshold *Th* depending on the acceptable relative error of the measurement during the zero crossing without compensation of the error, i.e. with the mid-point electric potential φmid set to ground.

The measurement voltages *Va,* Vb which are measured by the processing unit 10 are the electric potential differences between the first and second measurement electric potential φa, φb and ground. The mid-point voltage Vmid which is adjusted by the mid-point voltage adjustment unit 23 is the electric potential difference between the mid-point electric potential φmid and ground.

The adjustment of the mid-point voltage Vmid does not significantly alter the effective output signal of the current transducer representing the alternating current thanks to the differential measurement: the same difference in voltage is added to one branch as subtracted from the other branch connected to the subtractor 27.

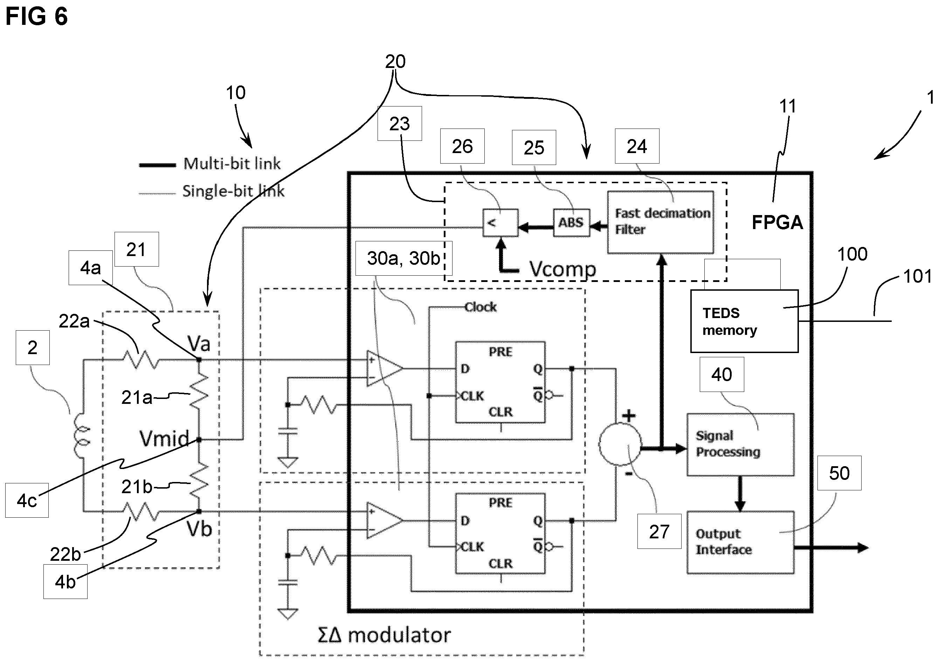

In the embodiment of figure 6, the mid-point voltage adjustment unit 23 is connected to an output of the subtractor and configured to adjust the mid-point electric potential φmid based on the output of the subtractor to maintain absolute values of electric potential differences of said first and second electric potentials with respect to ground *Va,* Vb greater than an error threshold *Th* for an alternating current with a peak amplitude smaller than a small amplitude current threshold *Th*₁.

In a variant (not shown in the figures), the mid-point voltage adjustment unit 23 is connected to outputs of the first and second analog-to-digital converters 30a, 30b and configured to adjust the mid-point electric potential φmid based on the outputs of the first and second analog-to-digital converters 30a, 30b to maintain absolute values of electric potential differences of said first and second electric potentials with respect to ground *Va,* Vb greater than an error threshold *Th* for an alternating current with a peak amplitude smaller than a small amplitude current threshold *Th*₁. In this variant, the mid-point voltage Vmid can be adjusted as a function of the outputs of the first and second analog-to-digital converters 30a, 30b as separate input parameters to the function.

In preferred embodiments, the mid-point voltage adjustment unit 23 is configured to detect that the absolute values of the measurement voltages *Va,* Vb at the inputs of the first and second analog-to-digital converters with respect to ground are both greater than the small amplitude voltage threshold *Th*₂ and thereupon set the mid-point electric potential φmid to ground. The detection is based on the output of the subtractor 27 or on the outputs of the first and second analog-to-digital converters 30a, 30b. In these embodiments, the linearity compensation network 20 does not sacrifice a large measurement range for the accuracy of the measurement of weak currents.

In a preferred embodiment, the mid-point voltage adjustment unit 23 is configured to detect that the absolute value of at least one of the measurement voltages *Va, V*b at the first and second analog-to-digital converters with respect to ground is below the small amplitude voltage threshold *Th*₂ and thereupon set the mid-point electric potential φmid to an adjustment voltage ΔV above ground or below ground. In the embodiment of figure 6, the adjustment voltage ΔV is the voltage corresponding to the logical "true" of the output of the comparator 26. However, this logical "true" voltage of a standard comparator can be converted into any other constant voltage using a circuit known to the skilled person in the art. The adjustment voltage ΔV is preferably selected in the range between 0.25 and 0.75 of the small amplitude voltage threshold *Th*₂. For example, the adjustment voltage ΔV is approximately half the small amplitude voltage threshold *Th*₂. The detection is based on the outputs of the first and second analog-to-digital converters 30a, 30b, for example, it is based on the output of the subtractor 27.

In a preferred embodiment, the mid-point voltage adjustment unit 23 comprises a decimation filter 24 connected to the output of the subtractor 27 and the mid-point voltage adjustment unit 23 is configured to adjust the mid-point electric potential φmid based on an output of the decimation filter 24 to maintain absolute values of measurement voltages *Va, V*b at the inputs of the first and second analog-to-digital converters with respect to ground greater than the error threshold *Th* for the alternating current with the peak amplitude smaller than the small amplitude current threshold *Th*₁.

In a preferred embodiment, the mid-point voltage adjustment unit 23 further comprises an absolute value unit 25 and a digital comparator 26. The absolute value unit 25 is configured to provide the absolute value of the output of the decimation filter 24. The mid-point voltage adjustment unit 23 is configured to detect by the comparator 26 the absolute value of the output of the decimation filter 24 being less than a predefined comparator voltage *V*comp and thereupon set the mid-point electric potential φmid to the adjustment voltage ΔV above ground or below ground and the mid-point voltage adjustment unit 23 is configured to detect by the comparator the absolute value of the output of the decimation filter 24 being greater than the predefined comparator voltage Vcomp and thereupon set the mid-point electric potential φmid to ground. Vcomp is a multi-bit number representing the small current amplitude threshold *Th*₁ or the small amplitude voltage threshold *Th*₂. In this embodiment, small alternating currents are completely moved out of the unreliability zone *r*₀ and can therefore be reliably measured. Large alternating currents can also be reliably measured because the relative error during the zero crossing is insignificant compared to the peak amplitudes.

In a variant (not shown in the figures), the adjustment voltage ΔV is a non-constant function of the output of the decimation filter, i.e., the adjustment voltage ΔV has more than one value or a quasi-continuous set of values. For example, the adjustment voltage ΔV increases with the peak amplitude of the alternating current. In particular, the adjustment voltage ΔV may linearly increase with the peak amplitude of the alternating current from a minimum value to a maximum value.

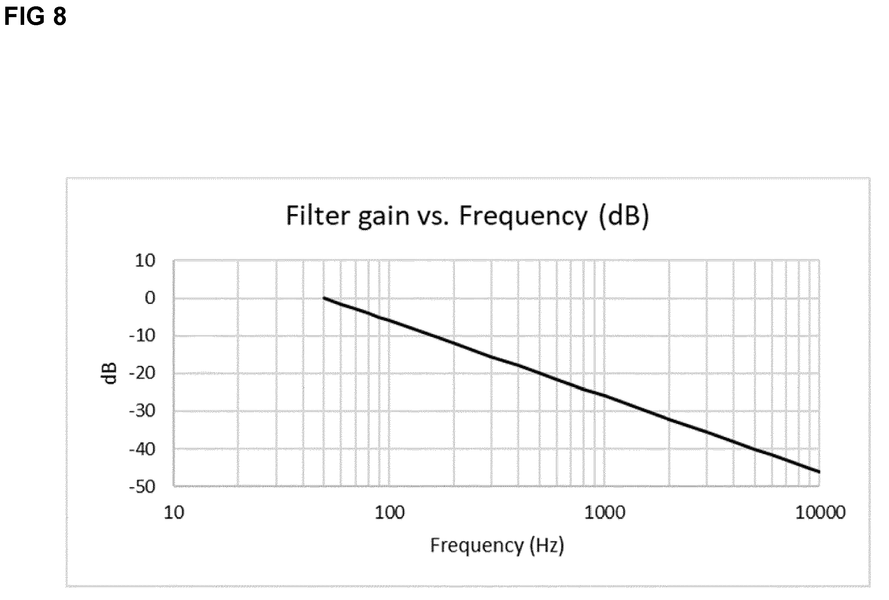

The processing unit 10 further comprises an output signal processing circuit 40 for producing the output signal representing the alternating current. The output signal processing circuit 40 is connected to the output of the subtractor 27 and comprises a digital low pass filter 45 for integrating an output signal of the subtractor 27. The signal is integrated in the digital low pass filter 45 because the induction voltage *e*(t) is proportional to the time derivative of the alternating current *I*ₚ to be measured. In preferred embodiments, the digital low pass filter 45 is implemented in the FPGA 11. The digital low pass filter 45 preferably has a transfer function of the form *Y = αZ + (1-α)Y⁻¹.* This is a pure first order transfer function, which guaranties the -20dB/decade needed for the integration of the output of the Rogowski coil (see figure 8). Furthermore, the phase remains constant at 90°. By choosing the coefficient *α* as the inverse of a power of 2, we can also get rid of the use of multipliers by just applying bit shifting in vectors.

In preferred embodiments, the output signal processing circuit 40 further comprises a gain calibration unit 41 for calibrating a gain of the inductor 2 and/or compensating a gain of the digital low pass filter 45. Preferably, the gain calibration is performed by gain calibration unit 41 prior to the integration by the low pass filter 45.

The gain calibration unit 41 comprises a multiplier 43 and a third sigma-delta modulator 42 with a constant input (i.e., a digital multi-bit number) corresponding to the gain of the inductor and/or the gain of the digital low pass filter. An output of the third sigma-delta modulator 42 is connected to an input of the multiplier. Another input of the multiplier is connected to the output of the subtractor 27 and an output of the multiplier 43 is connected to an input of the digital low pass filter 45. The output signal of the multiplier 43 is a multi-bit vector stream.

The implementation of sigma-delta modulators in FPGAs (digital multi-bit input, single-bit sigma-delta bitstream output) is well known and therefore not described herein.

The output signal of the current transducer representing the alternating current can have any desired format. A wide diversity of outputs can be generated by FPGA alone or in combination with additional components, e.g., passive components. The current transducer may also provide a plurality of output signals having different formats, such as an analog output signal and one or more digital output signal.

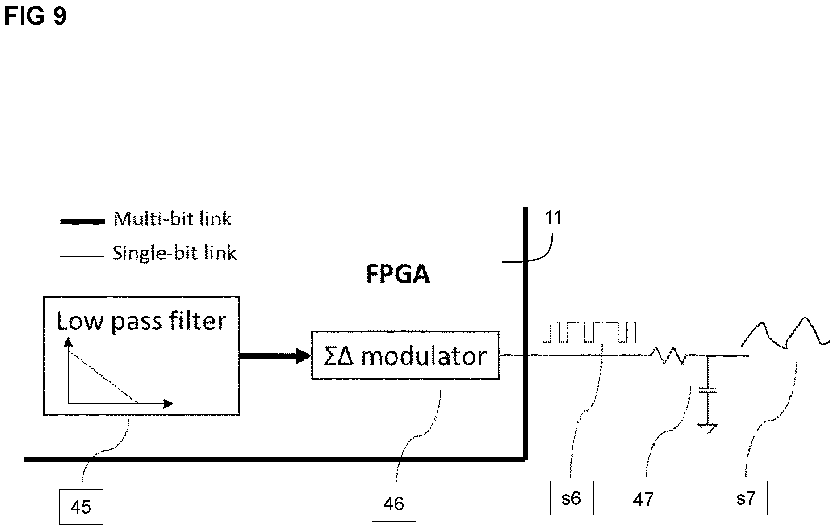

For example, an analog output signal may be provided as follows. In an embodiment, the output signal processing circuit 40 further comprises a fourth sigma-delta modulator 46 connected to an output of the digital low pass filter 45 and an external analog low pass filter 47 connected to an output of the fourth sigma-delta modulator 46 (see figure 9).

For example, the following digital output signal can be implemented in FPGAs:
- SPI
- ΣΔ
- 1 wire
- I2C
- MODBUS (with added external components)
- PROFIBUS (with added external components)
- ETHERNET (with added external components)

Being fully digital, the present invention enables the integration of the TEDS data in the FPGA without the need of an additional memory integrated circuit.

The current transducer 1 further comprises an output interface 50 for providing the output signal.

### List of references

Current transducer 1, 1'
Inductor, e.g., Rogowski coil 2, 2'
   Connection points 4a, 4b
   Number of windings *n*
   Average closed path *I*
   Cross section *S*
   Magnetic field B(t)
   Induction voltage e(t)
Primary conductor 3
   Primary current *I*ₚ
Processing unit 10, 10'
   FPGA 11
   Linearity compensation network 20
      Voltage divider 21
         Mid-point 4c
         Measurement resistors 21a, 21b
         Measurement electric potentials φa, φb
         Measurement voltages *Va, V*b
         Mid-point electric potential φmid
         Mid-point voltage Vmid
         Series resistors 22a, 22b
      Mid-point voltage adjustment unit 23
         Decimation filter 24
         Absolute value unit 25
         Comparator 26
            Comparator voltage *V*comp
      Subtractor 27
   Analog-to-digital converters
      Sigma-delta modulators 30, 30a, 30b
      Comparator 31
      Passive integration network
         Resistor 32
         Capacitor 33
      d-type flip-flop 34
      Clock 35
      Non-reliable measurement zone *r*₀
      Reliable measurement zones *r*₁, *r*₂
   Output signal processing circuit 40
      Gain calibration unit 41
         Sigma-delta modulator 42
         Digital multiplier 43
         Potentiometer 44'
      Digital low pass filter 45
      Sigma-delta modulator 46
      Low pass filter 47
   Output interface 50
   Analog input s1
   Bitstream(s) s2
   Subtraction of bitstreams s3
   Constant bitstream s4
   Gain calibrated waveform s5
   Output signal s6
   Filtered output signal s7
   TEDS memory 100, 100'
      One-wire communication 101, 101'
   Analog integrator 110'
      Operational amplifier 111'

## Claims

1. Current transducer (1) for measuring an alternating current in a conductor, the current transducer comprising
an inductor (2) having a first connection point (4a) at a first electric potential corresponding to a first measurement voltage *V*a with respect to ground and a second connection point (4b) at a second electric potential corresponding to a second measurement voltage *V*b with respect to ground, and
a processing unit (10) connected to the first and second connection points (4a, 4b) configured to convert an induction voltage induced in the inductor by said alternating current into an output signal of the current transducer representing a measurement of the alternating current,
the processing unit (10) comprising a first analog-to-digital converter (30a) connected to the first connection point (4a), a second analog-to-digital converter (30b) connected to the second connection point (4b), and a linearity compensation network (20),
**characterized in that**
the linearity compensation network (20) comprises:
a voltage divider (21) connected between the first and second connection points (4a, 4b) and having a mid-point (4c) at a mid-point electric potential (φmid) between the first electric potential and the second electric potential,
a subtractor (27) connected to an output of the first analog-to-digital converter (30a) and an output of the second analog-to-digital converter (30b), and
a mid-point voltage adjustment unit (23) connected to an output of the subtractor or outputs of the first and second analog-to-digital converters (30a, 30b), and configured to adjust the mid-point electric potential (φmid) based on the output of the subtractor or the outputs of the first and second analog-to-digital converters (30a, 30b) to maintain absolute values of the first and second measurement voltages *Va, V*b greater than an error threshold *Th* for an alternating current with a peak amplitude smaller than a small amplitude current threshold *Th*₁.

2. Current transducer according to any preceding claim, wherein the mid-point voltage adjustment unit (23) is configured to adjust the mid-point electric potential (φmid) based on the output of the subtractor or the outputs of the first and second analog-to-digital converters (30a, 30b) to maintain absolute values of the first and second measurement voltages *Va,* Vb greater than an error threshold *Th* for a voltage between the first and second connection points 4a, 4b smaller than twice a small amplitude voltage threshold *Th₂*, wherein an alternating current with a peak amplitude equals to the small amplitude current threshold *Th*₁ induces a peak induction voltage that creates a voltage between the first and second connection points (4a, 4b) of twice the small amplitude voltage threshold *Th*₂.

3. Current transducer according to any preceding claim, wherein the mid-point voltage adjustment unit (23) is configured to detect that the absolute values of the measurement voltages *Va, V*b at inputs of the first and second analog-to-digital converters with respect to ground are both greater than the small amplitude voltage threshold *Th*₂ and thereupon set the mid-point electric potential (φmid) to ground.

4. Current transducer according to any preceding claim, wherein the mid-point voltage adjustment unit (23) is configured to detect that the absolute value of at least one of the measurement voltages *Va, V*b at the inputs the first and second analog-to-digital converters with respect to ground is below the small amplitude voltage threshold *Th*₂ and thereupon set the mid-point electric potential (φmid) to an adjustment voltage ΔV above ground or below ground.

5. Current transducer according to the directly preceding claim, wherein the adjustment voltage ΔV is selected in the range between 0.25 and 0.75 of the small amplitude voltage threshold *Th*₂, for example, the adjustment voltage ΔV is approximately half the small amplitude voltage threshold *Th*₂.

6. Current transducer according to the directly preceding claim, wherein the mid-point voltage adjustment unit (23) comprises a decimation filter (24) connected to the output of the subtractor (27) and the mid-point voltage adjustment unit (23) is configured to adjust the mid-point electric potential (φmid) based on an output of the decimation filter (24) to maintain absolute values of measurement voltages *Va, V*b at the inputs of the first and second analog-to-digital converters with respect to ground greater than the error threshold *Th* for the alternating current with the peak amplitude smaller than the small amplitude threshold *Th*₁.

7. Current transducer according to the directly preceding claim, wherein the mid-point voltage adjustment unit (23) further comprises an absolute value unit (25) and a comparator (26), the absolute value unit (25) is configured to provide the absolute value of the output of the decimation filter (24), and the mid-point voltage adjustment unit (23) is configured to detect by the comparator the absolute value of the output of the decimation filter (24) being less than a predefined comparator voltage Vcomp and thereupon set the mid-point electric potential (φmid) to the adjustment voltage ΔV above ground or below ground and the mid-point voltage adjustment unit (23) is configured to detect by the comparator the absolute value of the output of the decimation filter (24) being greater than the predefined comparator voltage Vcomp and thereupon set the mid-point electric potential (φmid) to ground.

8. Current transducer according to any preceding claim, wherein the inductor (2) is a Rogowski coil.

9. Current transducer according to any preceding claim, wherein at least portions of the linearity compensation network (20) and the first and second analog-to-digital converters (30a, 30b) are implemented in a field-programmable gate array.

10. Current transducer according to any preceding claim, wherein the first and second analog-to-digital converters (30a, 30b) are sigma-delta modulators.

11. Current transducer according to any preceding claim, wherein the processing unit (10) further comprises an output signal processing circuit (40) for producing the output signal of the current transducer representing the alternating current, wherein the output signal processing circuit (40) is connected to the output of the subtractor (27) and comprises a digital low pass filter (45) for integrating an output signal of the subtractor (27).

12. Current transducer according to any preceding claim, wherein the digital low pass filter (45) has a transfer function of the form *Y = αZ + (1-α)Y⁻¹,* where the coefficient *α* is preferably an inverse of a power of 2.

13. Current transducer according to any preceding claim, wherein the output signal processing circuit (40) further comprises a gain calibration unit (41) for calibrating a gain of the inductor (2) and/or compensating a gain of the digital low pass filter (45).

14. Current transducer according to the directly preceding claim, wherein the gain calibration unit (41) comprises a multiplier (43) and a third sigma-delta modulator (42) with a constant input corresponding to the gain of the inductor and/or the gain of the digital low pass filter, wherein an output of the third sigma-delta modulator (42) is connected to an input of the multiplier, wherein another input of the multiplier is connected to the output of the subtractor (27) and an output of the multiplier (43) is connected to an input of the digital low pass filter (45).

15. Current transducer according to any one of the four directly preceding claims, wherein the output signal processing circuit (40) further comprises a fourth sigma-delta modulator (46) connected to an output of the digital low pass filter (45).

## Patentansprüche

1. Stromwandler (1) zum Messen eines Wechselstroms in einem Leiter, wobei der Stromwandler Folgendes umfasst
einen Induktor (2) mit einem ersten Verbindungspunkt (4a) an einem ersten elektrischen Potenzial, das einer ersten Messspannung *V*a mit Bezug auf Masse entspricht, und einem zweiten Verbindungspunkt (4b) mit einem zweiten elektrischen Potenzial, das einer zweiten Messspannung *V*b mit Bezug auf Masse entspricht, und
eine Verarbeitungseinheit (10), die mit dem ersten und dem zweiten Verbindungspunkt (4a, 4b) verbunden und dazu ausgelegt ist, eine vom Wechselstrom im Induktor induzierte Induktionsspannung in ein Ausgangssignal des Stromwandlers umzuwandeln, das eine Messung des Wechselstroms repräsentiert,
wobei die Verarbeitungseinheit (10) einen ersten Analog-Digital-Wandler (30a), der mit dem ersten Verbindungspunkt (4a) verbunden ist, einen zweiten Analog-Digital-Wandler (30b), der mit dem zweiten Verbindungspunkt (4b) verbunden ist, und ein Linearitätskompensationsnetzwerk (20) umfasst,
**dadurch gekennzeichnet, dass**
das Linearitätskompensationsnetzwerk (20) Folgendes umfasst:
einen Spannungsteiler (21), der zwischen dem ersten und dem zweiten Verbindungspunkt (4a, 4b) verbunden ist, und einen Mittelpunkt (4c) an einem elektrischen Mittelpunktpotenzial (φmid) zwischen dem ersten elektrischen Potenzial und dem zweiten elektrischen Potenzial aufweist,
einen Subtrahierer (27), der mit einem Ausgang des ersten Analog-Digital-Wandlers (30a) und einem Ausgang des zweiten Analog-Digital-Wandlers (30b) verbunden ist, und
eine Mittelpunktspannungsanpassungseinheit (23), die mit einem Ausgang des Subtrahierers oder mit dem Ausgang des ersten und des zweiten Analog-Digital-Wandlers (30a, 30b) verbunden und dazu ausgelegt ist, das elektrische Mittelpunktpotenzial (φmid) auf Basis des Ausgangs des Subtrahierers oder des Ausgangs des ersten und des zweiten Analog-Digital-Wandlers (30a, 30b) anzupassen, um absolute Werte der ersten und der zweiten Messspannung *V*a, *V*b aufrechtzuerhalten, die größer sind als ein Fehlerschwellwert *Th* für einen Wechselstrom mit einer Spitzenamplitude kleiner als ein kleiner Amplitudenstromschwellwert *Th*₁.

2. Stromwandler nach einem der vorhergehenden Ansprüche, wobei die Mittelpunktspannungsanpassungseinheit (23) dazu ausgelegt ist, das elektrische Mittelpunktpotenzial (φmid) auf Basis des Ausgangs des Subtrahierers oder des Ausgangs des ersten und des zweiten Analog-Digital-Wandlers (30a, 30b) anzupassen, um absolute Werte der ersten und der zweiten Messspannung *V*a, *V*b aufrechtzuerhalten, die größer sind als ein Fehlerschwellwert *Th* für eine Spannung zwischen dem ersten und dem zweiten Verbindungspunkt 4a, 4b, die kleiner ist als das Doppelte eines kleinen Amplitudenspannungsschwellwerts *Th*₂, wobei ein Wechselstrom mit einer Spitzenamplitude gleich dem kleinen Amplitudenstromschwellwert *Th*₁ eine Spitzeninduktionsspannung induziert, die eine Spannung zwischen dem ersten und dem zweiten Verbindungspunkt (4a, 4b) vom Doppelten des kleinen Amplitudenspannungsschwellwerts Th₂ erzeugt.

3. Stromwandler nach einem der vorhergehenden Ansprüche, wobei die Mittelpunktspannungsanpassungseinheit (23) dazu ausgelegt ist zu detektieren, dass die absoluten Werte der Messspannungen *V*a, *V*b an Eingängen des ersten und des zweiten Analog-Digital-Wandlers mit Bezug auf Masse beide größer sind als der kleine Amplitudenspannungsschwellwert *Th₂*, und danach das elektrische Mittelpunktpotenzial (φmid) auf Masse einzustellen.

4. Stromwandler nach einem der vorhergehenden Ansprüche, wobei die Mittelpunktspannungsanpassungseinheit (23) dazu ausgelegt ist zu detektieren, dass der absolute Wert von mindestens einer der Messspannungen *V*a, *V*b an den Eingängen des ersten und des zweiten Analog-Digital-Wandlers mit Bezug auf Masse unter dem kleinen Amplitudenspannungsschwellwert *Th*₂ liegt, und danach das elektrische Mittelpunktpotenzial (φmid) auf eine Anpassungsspannung ΔV über Masse oder unter Masse einzustellen.

5. Stromwandler nach dem direkt vorhergehenden Anspruch, wobei die Anpassungsspannung ΔV beispielsweise im Bereich zwischen 0,25 und 0,75 des kleinen Amplitudenspannungsschwellwerts *Th*₂ ausgewählt wird, wobei die Anpassungsspannung ΔV etwa die Hälfte des Amplitudenspannungsschwellwerts *Th*₂ beträgt.

6. Stromwandler nach dem direkt vorhergehenden Anspruch, wobei die Mittelpunktspannungsanpassungseinheit (23) ein Dezimierungsfilter (24) umfasst, das mit dem Ausgang des Subtrahierers (27) und der Mittelpunktspannungsanpassungseinheit (23) verbunden und dazu ausgelegt ist, das elektrische Mittelpunktpotenzial (φmid) auf Basis einer Ausgabe des Dezimierungsfilters (24) anzupassen, um absolute Werte von Messspannungen *V*a, *V*b an den Eingängen des ersten und des zweiten Analog-Digital-Wandlers mit Bezug auf Masse aufrechtzuerhalten, die größer sind als der Fehlerschwellwert *Th* für den Wechselstrom mit einer Spitzenamplitude, die kleiner ist als der kleine Amplitudenschwellwert *Th*₁.

7. Stromwandler nach dem direkt vorhergehenden Anspruch, wobei die Mittelpunktspannungsanpassungseinheit (23) ferner eine Absolutwerteinheit (25) und einen Komparator (26) umfasst, wobei die Absolutwerteinheit (25) dazu ausgelegt ist, den Absolutwert des Ausgangs des Dezimierungsfilters (24) bereitzustellen, und wobei die Mittelpunktspannungsanpassungseinheit (23) dazu ausgelegt ist, durch den Komparator zu detektieren, dass der Absolutwert des Ausgangs des Dezimierungsfilters (24) kleiner ist als eine vordefinierte Komparatorspannung *V*comp, und danach das elektrische Mittelpunktpotenzial (φmid) auf die Anpassungsspannung ΔV über Masse oder unter Masse einzustellen, und wobei die Mittelpunktspannungsanpassungseinheit (23) dazu ausgelegt ist, durch den Komparator zu detektieren, dass der absolute Wert des Ausgangs des Dezimierungsfilters (24) größer ist als die vordefinierte Komparatorspannung *V*comp, und danach das elektrische Mittelpunktpotenzial (φmid) auf Masse einzustellen.

8. Stromwandler nach einem der vorhergehenden Ansprüche, wobei der Induktor (2) eine Rogowski-Spule ist.

9. Stromwandler nach einem der vorhergehenden Ansprüche, wobei mindestens Abschnitte des Linearitätskompensationsnetzwerks (20) und des ersten und des zweiten Analog-Digital-Wandlers (30a, 30b) in einem feldprogrammierbaren Gatearray implementiert werden.

10. Stromwandler nach einem der vorhergehenden Ansprüche, wobei der erste und der zweite Analog-Digital-Wandler (30a, 30b) Sigma-Delta-Modulatoren sind.

11. Stromwandler nach einem der vorhergehenden Ansprüche, wobei die Verarbeitungseinheit (10) zum Produzieren eines Ausgangssignals des Stromwandlers, das den Wechselstrom repräsentiert, ferner eine Ausgangssignalverarbeitungsschaltung (40) umfasst, wobei die Ausgangssignalverarbeitungsschaltung (40) mit dem Ausgang des Subtrahierers (27) verbunden ist und ein digitales Tiefpassfilter (45) zum Integrieren eines Ausgangssignals des Subtrahierers (27) umfasst.

12. Stromwandler nach einem der vorhergehenden Ansprüche, wobei das digitale Tiefpassfilter (45) eine Transferfunktion der Form *Y* = *αZ* + (*1-α*)*Y*⁻¹ aufweist, wo der Koeffizient *α* vorzugsweise eine Inverse einer 2-er-Potenz ist.

13. Stromwandler nach einem der vorhergehenden Ansprüche, wobei die Ausgangssignalverarbeitungsschaltung (40) zum Kalibrieren einer Verstärkung des Induktors (2) und/oder zum Kompensieren einer Verstärkung des digitalen Tiefpassfilters (45) ferner eine Verstärkungskalibriereinheit (41) umfasst.

14. Stromwandler nach dem direkt vorhergehenden Anspruch, wobei die Verstärkungskalibriereinheit (41) einen Multiplizierer (43) und einen dritten Sigma-Delta-Modulator (42) mit einem konstanten Eingang umfasst, der der Verstärkung des Induktors und/oder der Verstärkung des digitalen Tiefpassfilters entspricht, wobei ein Ausgang des dritten Sigma-Delta-Modulators (42) mit einem Eingang des Multiplizierers verbunden ist, wobei ein weiterer Eingang des Multiplizierers mit dem Ausgang des Subtrahierers (27) verbunden ist und ein Ausgang des Multiplizierers (43) mit einem Eingang des digitalen Tiefpassfilters (45) verbunden ist.

15. Stromwandler nach einem der vier direkt vorhergehenden Ansprüche, wobei die Ausgangssignalverarbeitungsschaltung (40) ferner einen vierten Sigma-Delta-Modulator (46) umfasst, der mit einem Ausgang des digitalen Tiefpassfilters (45) verbunden ist.

## Revendications

1. Transducteur de courant (1) destiné à mesurer un courant alternatif dans un conducteur, le transducteur de courant comprenant
une inductance (2) ayant un premier point de connexion (4a) à un premier potentiel électrique correspondant à une première tension de mesure Va par rapport à la masse, et un deuxième point de connexion (4b) à un deuxième potentiel électrique correspondant à une deuxième tension de mesure Vb par rapport à la masse, et
une unité de traitement (10) connectée aux premier et deuxième points de connexion (4a, 4b) configurée pour convertir une tension d'induction induite dans l'inductance par ledit courant alternatif en un signal de sortie du transducteur de courant représentant une mesure du courant alternatif,
l'unité de traitement (10) comprenant un premier convertisseur analogique-numérique (30a) connecté au premier point de connexion (4a), un deuxième convertisseur analogique-numérique (30b) connecté au deuxième point de connexion (4b), et un réseau de compensation de linéarité (20),
**caractérisé en ce que**
le réseau de compensation de linéarité (20) comprend :
un diviseur de tension (21) connecté entre les premier et deuxième points de connexion (4a, 4b) et dont un point médian (4c) est à un potentiel électrique de point médian (φmid) entre le premier potentiel électrique et le deuxième potentiel électrique,
un soustracteur (27) connecté à une sortie du premier convertisseur analogique-numérique (30a) et à une sortie du deuxième convertisseur analogique-numérique (30b), et
une unité de réglage de tension de point médian (23) connectée à une sortie du soustracteur ou à des sorties des premier et deuxième convertisseurs analogique-numérique (30a, 30b), configurée pour régler le potentiel électrique de point médian (φmid) sur la base de la sortie du soustracteur ou des sorties des premier et deuxième convertisseurs analogique-numérique (30a, 30b) afin de maintenir les valeurs absolues des première et deuxième tensions de mesure Va, Vb supérieures à un seuil d'erreur Th pour un courant alternatif dont une amplitude de crête est inférieure à un seuil de courant de faible amplitude Th₁.

2. Transducteur de courant selon l'une des revendications précédentes, dans lequel l'unité de réglage de tension de point médian (23) est configurée pour régler le potentiel électrique de point médian (φmid) sur la base de la sortie du soustracteur ou des sorties des premier et deuxième convertisseurs analogique-numérique (30a, 30b) afin de maintenir les valeurs absolues des première et deuxième tensions de mesure Va, Vb supérieures à un seuil d'erreur Th pour une tension entre les premier et deuxième points de connexion (4a, 4b) inférieure au double d'un seuil de tension de faible amplitude Th₂, dans lequel un courant alternatif dont une amplitude de crête est égale au seuil de courant de faible amplitude Th₁ induit une tension d'induction de crête qui crée une tension entre les premier et deuxième points de connexion (4a, 4b) égale au double du seuil de tension de faible amplitude Th₂.

3. Transducteur de courant selon l'une des revendications précédentes, dans lequel l'unité de réglage de tension de point médian (23) est configurée pour détecter que les valeurs absolues des tensions de mesure Va, Vb aux entrées des premier et deuxième convertisseurs analogique-numérique par rapport à la masse sont toutes deux supérieures au seuil de tension de faible amplitude Th₂ et sur cette base, définir le potentiel électrique de point médian (φmid) à la masse.

4. Transducteur de courant selon l'une des revendications précédentes, dans lequel l'unité de réglage de tension de point médian (23) est configurée pour détecter que la valeur absolue d'au moins une des tensions de mesure Va, Vb aux entrées des premier et deuxième convertisseurs analogique-numérique par rapport à la masse est en dessous du seuil de tension de faible amplitude Th₂ et sur cette base, définir le potentiel électrique de point médian (φmid) à une tension de réglage ΔV au-dessus de la masse ou en dessous de la masse.

5. Transducteur de courant selon la revendication directement précédente, dans lequel la tension de réglage ΔV est choisie dans la plage entre 0,25 et 0,75 du seuil de tension de faible amplitude Th₂, par exemple, la tension de réglage ΔV est approximativement égale à la moitié du seuil de tension de faible amplitude Th₂.

6. Transducteur de courant selon la revendication directement précédente, dans lequel l'unité de réglage de tension de point médian (23) comprend un filtre de décimation (24) connecté à la sortie du soustracteur (27), et l'unité de réglage de tension de point médian (23) est configurée pour régler le potentiel électrique de point médian (φmid) sur la base d'une sortie du filtre de décimation (24) afin de maintenir les valeurs absolues des tensions de mesure Va, Vb aux entrées des premier et deuxième convertisseurs analogique-numérique par rapport à la masse supérieures au seuil d'erreur Th pour le courant alternatif dont l'amplitude de crête est inférieure au seuil de faible amplitude Th₁.

7. Transducteur de courant selon la revendication directement précédente, dans lequel l'unité de réglage de tension de point médian (23) comprend en outre une unité de valeur absolue (25) et un comparateur (26), l'unité de valeur absolue (25) est configurée pour fournir la valeur absolue de la sortie du filtre de décimation (24), et l'unité de réglage de tension de point médian (23) est configurée pour détecter par le comparateur quand la valeur absolue de la sortie du filtre de décimation (24) est inférieure à une tension de comparaison Vcomp prédéfinie et sur cette base, définir le potentiel électrique de point médian (φmid) à la tension de réglage ΔV au-dessus de la masse ou en dessous de la masse, et l'unité de réglage de tension de point médian (23) est configurée pour détecter par le comparateur quand la valeur absolue de la sortie du filtre de décimation (24) est supérieure à la tension de comparaison Vcomp prédéfinie et sur cette base, définir le potentiel électrique de point médian (φmid) à la masse.

8. Transducteur de courant selon l'une des revendications précédentes, dans lequel l'inductance (2) est une bobine de Rogowski.

9. Transducteur de courant selon l'une des revendications précédentes, dans lequel au moins des parties du réseau de compensation de linéarité (20) et des premier et deuxième convertisseurs analogique-numérique (30a, 30b) sont mises en œuvre dans un réseau de portes programmable.

10. Transducteur de courant selon l'une des revendications précédentes, dans lequel les premier et deuxième convertisseurs analogique-numérique (30a, 30b) sont des modulateurs sigma-delta.

11. Transducteur de courant selon l'une des revendications précédentes, dans lequel l'unité de traitement (10) comprend en outre un circuit de traitement de signaux de sortie (40) pour produire le signal de sortie du transducteur de courant représentant le courant alternatif, dans lequel le circuit de traitement de signaux de sortie (40) est connecté à la sortie du soustracteur (27) et comprend un filtre passe-bas numérique (45) pour intégrer un signal de sortie du soustracteur (27).

12. Transducteur de courant selon l'une des revendications précédentes, dans lequel le filtre passe-bas numérique (45) présente une fonction de transfert de la forme *Y = αZ + (1* -*α)Y⁻¹*, où le coefficient *α* est de préférence l'inverse d'une puissance de 2.

13. Transducteur de courant selon l'une des revendications précédentes, dans lequel le circuit de traitement de signaux de sortie (40) comprend en outre une unité d'étalonnage de gain (41) pour étalonner un gain de l'inductance (2) et/ou compenser un gain du filtre passe-bas numérique (45).

14. Transducteur de courant selon la revendication directement précédente, dans lequel l'unité d'étalonnage de gain (41) comprend un multiplicateur (43) et un troisième modulateur sigma-delta (42) avec une entrée constante correspondant au gain de l'inductance et/ou au gain du filtre passe-bas numérique, dans lequel une sortie du troisième modulateur sigma-delta (42) est connectée à une entrée du multiplicateur, dans lequel une autre entrée du multiplicateur est connectée à la sortie du soustracteur (27) et une sortie du multiplicateur (43) est connectée à une entrée du filtre passe-bas numérique (45).

15. Transducteur de courant selon l'une des quatre revendications directement précédentes, dans lequel le circuit de traitement de signaux de sortie (40) comprend en outre un quatrième modulateur sigma-delta (46) connecté à une sortie du filtre passe-bas numérique (45).
